# EUROPÄISCHE PATENTSCHRIFT

(11) **EP 0 961 411 B1**
(45) Veröffentlichungstag und Bekanntmachung des Hinweises auf die Patenterteilung: **15.09.2004**
(21) Anmeldenummer: 98109712.4
(22) Anmeldetag: 28.05.1998
(51) Int. Cl.: H03L 7/00, G01R 23/00, G01R 21/133

(54) **Verfahren zur Ableitung einer Frequenz eines Taktsignals**
Procedure for deriving a clock frequency
Procédé pour dériver une fréquence d'horloge

(43) Veröffentlichungstag der Anmeldung: 01.12.1999
(73) Patentinhaber: Landis+Gyr AG, 6300 Zug (CH)
(72) Erfinder: Bammert, Kurt, 6343 Rotkreuz (CH); Bulinsky, Mirko, 6006 Luzern (CH); Schaller, Michel, 6340 Baar (CH)
(74) Vertreter: Heusch, Christian

(56) Entgegenhaltungen:
- GB-A- 2 069 153
- GB-A- 2 132 042
- US-A- 3 993 984
- US-A- 4 902 964
- PAUL C R: "CIRCUIT BOUNDS OUTPUT FREQUENCY" EDN ELECTRICAL DESIGN NEWS, Bd. 34, Nr. 5, 2. März 1989, Seite 175 XP000120419

## Beschreibung

Die Erfindung bezieht sich auf ein Verfahren zur Ableitung bzw. Kalibration einer Frequenz eines Taktsignals gemäss dem Oberbegriff des Anspruchs 1 bzw. 4.

Das Verfahren wird in elektronischen Geräten verwendet, vorzugsweise in Elektrizitätszählern, Tarifgeräten, Rundsteuerempfängern oder Kombinationen dieser Geräte.

Ein Verfahren der eingangs genannten Art ist aus der US-PS 5,644,271 bekannt, in der die Kompensation einer temperaturbedingten Frequenzdrift eines digitalen Taktsignals beschrieben wird, welches von einem Oszilattor erzeugt wird und dessen Frequenz von der Temperatur abhängig ist. Die Temperatur wird mittels eines Sensors, z. B. eines Thermistors gemessen, dessen analoges Ausgangssignal mittels eines Analog/Digital-Wandlers in ein digitales Signal umgewandelt wird. Der digitale Wert des letzteren dient als Adresse eines Speichers, in dem tabellenförmig Korrekturwerte der Frequenz in Funktion der Temperatur abgespeichert sind. Der Datenausgang des Speichers ist über einem Akkumulator auf ein Verzögerungsglied geführt, welches z. B. aus einem Zähler besteht, dessen Takteingang von einem Referenzfrequenz-Taktsignal gespeist ist, welches von einem Referenz-Quarzoszillator erzeugt wird. Der Zähler zählt die Impulse des letzteren. Die Verzögerungszeit des Verzögerungsglied ist digital einstellbar, indem ein Korrekturwert parallel in den Zähler geladen wird, welcher dann - beim Korrekturwert beginnend -rückwärts bis Null zählt und beim Erreichen des Nullwertes einen Ausgangsimpuls erzeugt. Das Ausgangsignal des Verzögerungsgliedes besteht somit aus temperaturabhängig verzögerten Impulsen, die das temperaturkompensierte Taktsignal bilden.

Bekannt ist auch US-PS 4,902,964, in der ein Elektrizitätszähler mit Verbrauchsregister ("demand register") beschrieben ist. Das letztere ermittelt mittels eines Mikrocomputers über programmierte Zeitperioden akkumulierte und gespeicherte Verbrauchsdaten. Dabei ist die Kenntnis der genauen Realzeit von essentieller Bedeutung. Zu diesem Zweck wird ein für den Mikrocomputer benötigtes Taktsignal von einer 50 Hz- oder 60 Hz-Netzfrequenz abgeleitet, wobei Perioden eines Netzsignals mit Hilfe einer mittels eines Quarzoszillators erzeugten Referenzfrequenz ermittelt werden. Ein Zähler ermittelt die Netzperioden, indem er die zwischen zwei aufeinanderfolgende Nulldurchgänge der Netzfrequenz vorhandenen Impulse der Referenfrequenz zählt. Anschliessend stellt ein Frequenzkomparator unter Berücksichtigung der zulässigen Frequenz-Toleranzen fest, ob die ermittelte Netzperiode eine 50 Hz- oder eine 60 Hz-Periode ist, worauf der Zählwert eines zugehörigen 50 Hz- bzw. 60 Hz-Zählers inkrementiert wird. Sobald der Zählwert eines dieser Zähler den Wert fünf erreicht hat, was fünf Nulldurchgangs-Abstände der betreffenden Frequenz entspricht, werden die Operationsparameter des Mikrocomputers und des Programm-Taktsignals entsprechend der ermittelten Netzperiode automatisch gesetzt.

Der Erfindung liegt die Aufgabe zugrunde, ein Verfahren der eingangs genannten Art zu realisieren, welches es ermöglicht, temperatur- und/oder nichttemperaturbedingte unerwünschte Frequenzänderungen eines Taktsignals auf einfache und preisgünstige Weise sowie mit geringem schaltungstechnischem Aufwand automatisch zu kompensieren, unter Benutzung, nach Möglichkeit, bereits vorhandener Bauteile und ohne, dass dabei ein zweiter Oszillator erforderlich ist. Solche bereits in Elektrizitätszählern, Tarifgeräten, Rundsteuerempfängern oder Kombinationen dieser Geräte vorhandene Bauteile sind z. B. Teiler, deren Teilungsfaktor Zwei ist.

Die genannte Aufgabe wird erfindungsgemäss durch die im Kennzeichen des Anspruchs 1 angegebenen Merkmale gelöst. Vorteilhafte Ausgestaltungen der Erfindung ergeben sich aus den abhängigen Ansprüchen.

Ein Ausführungsbeispiel der Erfindung ist in der Zeichnung dargestellt und wird im folgenden näher beschrieben.

Es zeigen:
- Fig. 1: ein Blockschaltbild eines mit einem Taktgeber verbundenen Mikrocomputers,
- Fig. 2: ein Blockschaltbild des Taktgebers,

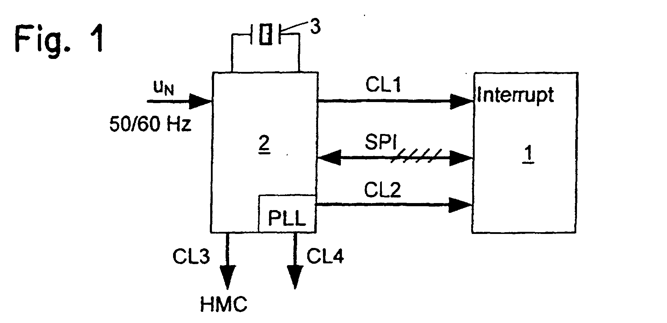

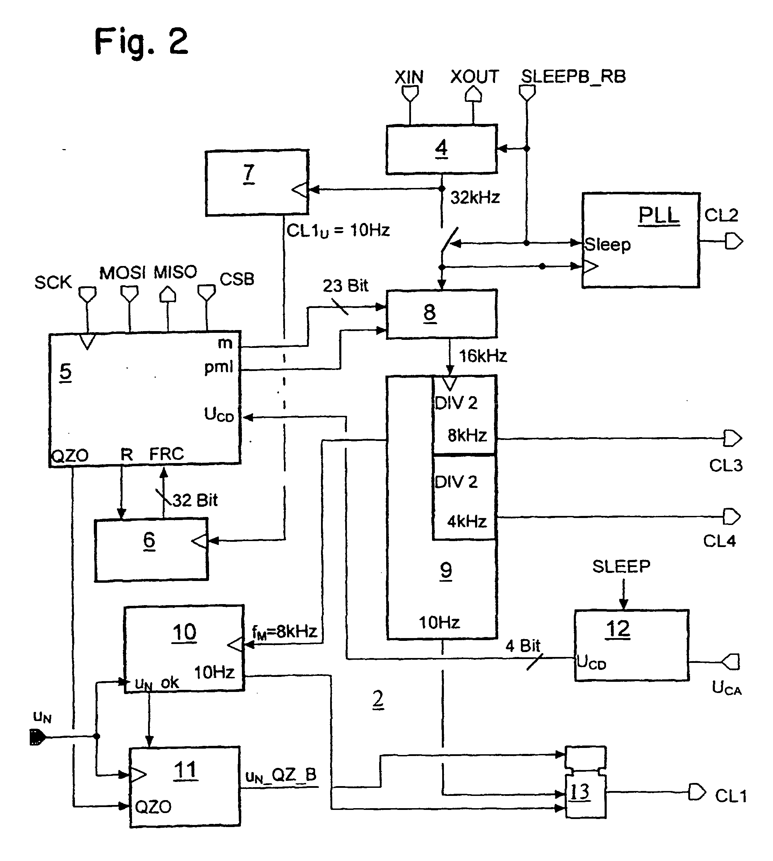

In vielen elektronischen Geräten, vor allem aber in Elektrizitätszählern, Tarifgeräten, Rundsteuerempfängern und Kombinationen dieser Geräten, wird heutzutage die Realzeit ("real time") benötigt, also das genaue Kalenderdatum und die genaue Uhrzeit. Solche Geräte enthalten in der Regel einen Mikrocomputer 1 und einen Taktgeber 2 (siehe Fig. 1). Der letztere weist einen Oszillator 4 auf (siehe Figur 2), der vorzugsweise ein mit einem Quarz 3 bestückter Quarzoszillator ist. Im letzteren Fall ist der Taktgeber 2 extern mit dem Quarz 3 beschaltet (siehe Fig. 1) und erzeugt der Oszillator 4 ein Taktsignal, dessen Frequenz einer Quarzfrequenz entspricht. Nachfolgend wird die Oszillatorfrequenz mit f_{Q} bezeichnet und beträgt z. B. 32, 768 kHz. Eine Realzeit-Funktion ist im Mikrocomputer 1 als Software implementiert. Mit Hilfe des Taktgebers 2 kann die Realzeit mit einer gewünschten Genauigkeit ermittelt werden.

Nachfolgend wird die Erfindung anhand des Beispiels eines Elektrizitätszählers näher beschrieben. In modernen Elektrizitätszählern wird zur Verrechnung gemessener Energie die genaue Realzeit benötigt, bei der Energiemessungen stattgefunden haben. Der Elektrizitätszähler enthält mindestens einen, in der Zeichnung nicht dargestellten Sensor HMC, mit dem z. B. eine zur gemessenen Energie gehörende Leistung p_{N} ermittelt wird. Die Ausgangsfrequenz des Sensors HMC ist vorzugsweise proportional der ermittelten Leistung p_{N} = u_{N} · i_{N} , wobei u_{N} eine Netzspannung eines Energieversorgungsnetzes und i_{N} ein zur ermittelten Leistung p_{N} gehörender Strom ist. Im Taktgeber 2 des Elektrizitätszählers werden z. B. vier Taktsignale CL1, CL2, CL3 und CL4 erzeugt (siehe Fig. 1). Zwei dieser Taktssignale, nämlich CL1 und CL2, werden vom Mikrocomputer 1 benötigt und über je eine getrennte Verbindung vom Taktgeber 2 dem Mikrocomputer 1 zugeführt. Zwischen dem Mikrocomputer 1 und dem Taktgeber 2 ist ausserdem eine normierte bidirektionelle SPI-Verbindung vorhanden, mittels welcher Informationen synchron zeitseriell in beiden Richtungen zwischen dem Mikrocomputer 1 und dem Taktgeber 2 übertragbar sind. Der Mikrocomputer 1 empfängt das Taktsignal CL1, dessen Frequenz f_{T} z. B. 10Hz beträgt, auf seinen Interrupteingang. Die Frequenz f_{T} des Taktsignals CL1 ist von der Oszillatorfrequenz f_{Q} des im Taktgeber 2 enthaltenen Oszillators 4 oder von einer Netzfrequenz f_{N} des Energieversorgungsnetzes abgeleitet. Die Netzspannung u_{N} des Energieversorgungsnetzes speist für den letzteren Fall einen Eingang des Taktgebers 2 und stellt diesem die Netzfrequenz f_{N} zur Verfügung, welche bekanntlich in Europa 50 Hz und in den USA 60 Hz beträgt. Das Taktsignal CL1 wird z. B. mittels eines SPI-Befehls, der vom Mikrocomputer 1 über die SPI-Verbindung dem Taktgeber 2 zugeleitet wird, wahlweise von der Oszillatorfrequenz f_{Q} oder der Netzfrequenz f_{N} abgeleitet. Die Frequenzen der drei Taktsignale CL2, CL3 und CL4 sind dagegen immer von der Oszillatorfrequenz f_{Q} abgeleitet. Die letztere ist, wie bereits erwähnt, vorzugsweise eine Quarzoszillator-Frequenz. Für den Mikrocomputer 1 ist die 10Hz-Frequenz des Taltsignals CL1 als exakt anzusehen, so dass - ausser nach einem Spannungsunterbruch - keine Genauigkeitskorrektur mittels einer Mikrocomputer-Software erforderlich ist. Das Taktsignal CL2 seinerseits bildet den Prozessortakt des Mikrocomputers 1. Zu seiner Erzeugung enthält der Taktgeber 2 z. B. einen Phasenregelkreis PLL ("phase locked loop"), dessen Takteingang mit einem Ausgang des Oszillators 4 verbunden ist. Mit Hilfe des Phasenregelkreises PLL wird - ausgehend von der Oszillatorfrequenz f_{Q}- durch Frequenz-Vervielfachung das Taktsignal CL2 erzeugt, dessen Frequenz z. B. 150 mal grösser ist als die Oszillatorfrequenz f_{Q}, nämlich z. B. 5 MHz. Das Taktsignal CL3 speist über einen getrennten Ausgang des Taktgebers 2 den Sensor HMC. Die Frequenz des Taktsignals CL3 dient unter anderem als Messfrequenz f_{M}: Wenn die Frequenz f_{T} des Taktsignals CL1 von der Netzfrequenz f_{N} abgeleitet wird, werden Perioden T_{N} eines die Netzfrequenz f_{N} aufweisenden Netzfrequenz-Taktsignals mit Hilfe der von der Oszillatorfrequenz f_{Q} bzw. Quarzoszillator-Frequenz abgeleiteten Messfrequenz f_{M} gemessen zur Ermittlung mindestens einer Periode T_{N} der Netzspannung u_{N}, unter anderem mit dem Ziel eine automatische 50Hz/60Hz-Umschaltung zu realisieren. Die Frequenz des Taktsignals CL3 ist z. B. 8,192 kHz, während diejenige des Taksignals CL4 z. B. 4,096 kHz beträgt. Die letztere dient unter anderem zur frequenzmässigen Ausmessung der Oszillatorfrequenz f_{Q}. Die Frequenz des Taktsignals CL4 ist in diesem Fall nicht kalibriert und wird, was in der Zeichnung nicht dargestellt ist, mit einer Referenzfrequenz f_{R} verglichen zur Ermittlung eines Frequenz-Korrekturwertes m. Dieser mit Hilfe der Referenzfrequenz f_{R} ermittelte Frequenz-Korrekturwert m wird in einen Speicher des Mikrocomputers 1 gespeichert. Das Taktsignal CL4 ist über einen getrennten Ausgang des Taktgebers 2 von aussen messbar.

Aus der Fig. 2 ist der innere Aufbau des Taktgebers 2 ersichtlich. Dieser enthält ausser den Phasenregelkreis PLL und den Oszillator 4 eine SPI-Schnittstelle 5, einen freilaufenden Zähler 6, einen ersten Frequenzteiler 7, eine Frequenzkorrektur-Schaltung 8, einen zweiten Frequenzteiler 9, einen Netzfrequenz-Zähler 10, eine Umschalt-Steuerschaltung 11, einen Analog/Digital-Wandler 12 sowie einen Multiplexer 13. Der in der Fig. 2 nichtdargestellte Quarz 3 ist zwischen zwei Klemmen XIN und XOUT des Oszillators 4 angeschlossen, falls dieser ein Quarzoszillator ist. Der Quarz 3 ist dann vorzugsweise die einzige chipexterne Komponente des Oszillators 4 und des Taktgebers 2. Alle anderen Bauelemente derselben sind in einem Chip integriert. Die SPI-Schnittstelle 5 dient zur Kommunikation zwischen dem Mikrocomputer 1 und dem Taktgeber 2, wobei der letztere immer als Sklave arbeitet. Mit entsprechenden Telegrammen können z.B. Funktionsparameter des Taktgebers 2 gesetzt oder gelesen werden sowie der freilaufende Zähler 6 auf Null zurückgestellt werden. Die SPI-Verbindung weist vier Verbindungsdrähte auf, die jeweils an einem SCK-Eingang ("shift clock"), einem MOSI-Eingang ("master out, slave in"), einem CSB-Eingang ("chip select") oder einem MISO-Ausgang ("master in, slave out") der normierten SPI-Schnittstelle 5 angeschlossen sind.

Der Taktgeber 2 erfasst und beurteilt die Netzfrequenz f_{N}, wobei erkannt wird, ob eine 50Hz- oder 60Hz-Netzspannung u_{N} vorhanden ist. Zu diesem Zweck ist die Netzspannung u_{N} auf einen Eingang des Netzfrequenz-Zählers 10 geführt, welcher ihre Periodendauer misst mit Hilfe der von der Oszillatorfrequenz f_{Q} mit Hilfe der Frequenzkorrektur-Schaltung 8 und des zweiten Frequenzteilers 9 abgeleiteten kalibrieten 8,192 kHz-Taktfrequenz des Taktsignals CL3, die - wie bereits erwähnt - dem Takteingang des Netzfrequenz-Zählers 10 zugeführt ist. Befindet sich eine zu 50Hz oder 60Hz gehörige Netzperiode T_{N} innerhalb einer Toleranzgrenze von ±5% so erscheint an einem mit u_{N}_ok bezeichneten Ausgang des Netzfrequenz-Zählers 10 ein Logikwert "1", der einem Steuereingang der Umschalt-Steuerschaltung 11 zugeführt ist. In der nachfolgenden Tabelle sind die ±5%- Frequenz-Toleranzgrenzen der Energieversorgungs-Spannung u_{N} angegeben. Der Netzfrequenz-Zähler 10 zählt die Anzahl der 8,192 kHz-Impulse des Taktsignals CL3, die zwischen zwei aufeinanderfolgenden positiven Flanken eines Netzfrequenz-Taktsignals vorhanden sind, welches von der Netzspannung u_{N} abgeleitet ist und deren Frequenz besitzt. Werden also z.B. 156 Impulse gezählt, so liegt die Netzfrequenz f_{N} gemäss der nachfolgenden Tabelle innerhalb des 50Hz ±5%- Frequenzbandes und ein entsprechendes Statusbit wird gesetzt, was einem Logikwert "1" am Ausgang u_{N}_ok des Netzfrequenz-Zählers 10 entspricht.

| | | | | | |
|---|---|---|---|---|---|
| Anzahl der 8,192 kHz-Impulse | - | 172.....156 | - | 144.....130 | - |
| Netzfrequenz | < 50Hz-5% | 50Hz±5% | - | 60Hz±5% | >60Hz+5% |

Die Netzfrequenz f_{N} kann also mindestens zwei Frequenzwerte, in der Regel 50 Hz und 60 Hz, besitzen. Mittels der gemessenen Perioden T_{N} des Netzfrequenz-Taktsignals wird jeweils der Frequenzwert des letzteren ermittelt zwecks Wahl eines zugehörigen korrekten Teilungsfaktors zur Ableitung der gewünschten Frequenz f_{T}, z. B. 10 Hz, des Taktsignals CL1 von der Netzfrequenz f_{N}. Innerhalb des Netzfrequenz-Zählers 10 sind daher - nicht dargestellt - zwei Teiler vorhanden, einer für 50 Hz und einer für 60 Hz, welche aus der Energieversorgungs-Spannung u_{N} bzw. dem Netzfrequenz-Taktsignal in jedem Fall ein 10Hz-Taktsignal erzeugen, welches an einem mit 10Hz bezeichneten Ausgang des Netzfrequenz-Zählers 10 erscheint und einem zweiten Eingang des Multiplexers 13 zugeführt ist. Ein Ausgangssignal u_{N}_QZ_B am Ausgang der Umschalt-Steuerschaltung 11 ist auf einen Steuereingang des Multiplexers 13 geführt. Mit Hilfe des Ausgangssignals u_{N}_QZ_B wird der erste oder zweite Eingang des Multiplexers 13 auf dessen Ausgang durchgeschaltet. Der letztere ist gleichzeitig ein mit CL1 bezeichneter Ausgang des Taktgebers 2, der gemäss Darstellung in der Fig. 1 mit dem Interrupt-Eingang des Mikrocomputers 1 verbunden ist und an dem in beiden Fällen ein kalibriertes 10Hz-Taktsignal CL1 ansteht. Die 10Hz-Frequenz ist dabei also entweder von der Oszillatorfrequenz f_{Q} oder von der Netzfrequenz f_{N} abgeleitet, je nachdem, ob der erste oder zweite Eingang des Multiplexers 13 durchgeschaltet ist.

Der Taktgeber 2 kennt somit zwei Betriebsarten zu Erzeugung des als Mikrocomputer-Interruptsignal verwendeten kalibrierten 10 HZ-Taktsignals CL1, wobei die Betriebsart mittels eines SPI-Telegramms vom Mikrocomputer 1 her wählbar ist. Durch diese Wahl erscheint entweder ein Logikwert "0" oder ein Logikwert "1" an einem mit QZO bezeichneten Ausgang der SPI-Schnittstelle 5, der mit einem Steuereingang QZO der Umschalt-Steuerschaltung 11 verbunden ist. Ein Takteingang der letzteren ist von der Netzspannung u_{N} gespeist. In einer ersten der beiden Betriebsarten ist die Frequenz f_{T} des Taktsignals CL1 ausschliesslich von der Oszillatorfrequenz f_{Q} abgeleitet, was einem Logikwert "0" am Ausgang QZO der SPI-Schnittstelle 5 entspricht. Dieser Logikwert "0" erzeugt über die Umschalt-Steuerschaltung 11 einen Logikwert "0" an deren Ausgang u_{N}_QZ_B, wodurch, wie bereits erwähnt, der erste Eingang des Multiplexers 13, an dem das von der Oszillatorfrequenz f_{Q} abgeleitete 10Hz-Taktsignal ansteht, auf den Ausgang des Multiplexers 13 durchgeschaltet wird. In der anderen, zweiten Betriebsart erfolgt die Ableitung der Frequenz f_{T} des Taktsignals CL1 von der Netzfrequenz f_{N}, allerdings wird zur Erzeugung der Frequenz f_{T} des Taktsignals CL1 die Netzfrequenz f_{N} nur verwendet, wenn die gemessenen Perioden T_{N} des Netzfrequenz-Taktsignals innerhalb vorgegebener Toleranzgrenzen liegen, ansonsten die Frequenz f_{T} des Taktsignals CL1 von der Oszillatorfrequenz f_{Q} abgeleitet wird. Die zur Messung der Perioden T_{N} verwendete, von der Oszillatorfrequenz f_{Q} abgeleitete Messfrequenz f_{M} ist vorzugsweise, genau wie die von der Oszillatorfrequenz f_{Q} abgeleitete Frequenz f_{T} des Taktsignals CL1, kalibriert. Zur Kalibrierung der Messfrequenz f_{M} sowie der Frequenz f_{T} des Taktsignals CL1 wird dabei vorzugsweise die gleiche, bereits erwähnte annähernd halbierte Grundfrequenz f_{G} verwendet. In der zweiten Betriebsart ist ein Logikwert "1" am Ausgang QZO der SPI-Schnittstelle 5 vorhanden. Dieser Logikwert "1" erzeugt über die Umschalt-Steuerschaltung 11 einen Logikwert "1" an deren Ausgang u_{N}_QZ_B, wodurch der zweite Eingang des Multiplexers 13, an dem das von der Netzfrequenz f_{N} abgeleitete 10Hz-Taktsignal ansteht, auf den Ausgang des Multiplexers 13 durchgeschaltet wird, allerdings nur unter der Bedingung, dass am mit u_{N}_ok bezeichneten Ausgang des Netzfrequenz-Zählers 10 ein Logikwert "1" ansteht. Letzteres ist nur der Fall, wenn die Netzperiode T_{N} sich innerhalb der erlaubten Toleranzgrenzen befindet.

Im Fall einer frequenzmässig zu ungenauen Netzspannung u_{N} schaltet der Taktgeber 2 auch bei Vorhandensein eines Logikwertes "1" am Ausgang QZO der SPI-Schnittstelle 5 (zweite Betriebsart) automatisch um auf die von der Oszillatorfrequenz f_{Q} abgeleitete Frequenz f_{T}, indem am mit u_{N}_ok bezeichneten Ausgang des Netzfrequenz-Zählers 10 ein Logikwert "0" erscheint, worauf das Ausgangssignal u_{N}_QZ_B der Umschalt-Steuerschaltung 11 einen Logikwert "0" annimmt, der den ersten Eingang des Multiplexers 13, an dem das von der Oszillatorfrequenz f_{Q} abgeleitete 10Hz-Taktsignal ansteht, auf den Ausgang des Multiplexers 13 durchschaltet. Die Umschaltung ist wie folgt implementiert: Zum Umschalten von der Oszillatorfrequenz f_{Q} auf die Netzfrequenz f_{N}, müssen z. B. 16 aufeinanderfolgende, innerhalb der Toleranzgrenzen liegende Netzperioden T_{N} gemessen werden. Umgekehrt erfolgt die Umschaltung von der Netzfrequenz f_{N} auf die Oszillatorfrequenz f_{Q} sofort nach einer ersten zu ungenauen Netzperiode T_{N}.

## Patentansprüche

1. Verfahren zur Ableitung einer Frequenz (f_{T}) eines Taktsignals (CL1) von einer Netzfrequenz (f_{N}), wobei Perioden (T_{N}) eines die Netzfrequenz (f_{N}) aufweisenden Netzfrequenz-Taktsignals mit Hilfe einer von einer Oszillatorfrequenz (f_{Q}), vorzugsweise einer Quarzoszillator-Frequenz abgeleiteten Messfrequenz (f_{M}) gemessen werden, **dadurch gekennzeichnet, dass** zur Erzeugung der Frequenz (f_{T}) des Taktsignals (CL1) die Netzfrequenz (f_{N}) verwendet wird, wenn die gemessenen Perioden (T_{N}) des Netzfrequenz-Taktsignals innerhalb vorgegebener Toleranzgrenzen liegen, ansonsten die Frequenz (f_{T}) des Taktsignals (CL1) von der Oszillatorfrequenz (f_{Q}) abgeleitet wird.

2. Verfahren nach Anspruch 1, **dadurch gekennzeichnet, dass** die von der Oszillatorfrequenz (f_{Q}) abgeleitete Messfrequenz (f_{M}) und die von der Oszillatorfrequenz (f_{Q}) abgeleitete Frequenz (f_{T}) des Taktsignals (CL1) kalibriert sind.

3. Verfahren nach einem der Ansprüche 1 bis 2, **dadurch gekennzeichnet, dass** die Netzfrequenz (f_{N}), mindestens zwei Frequenzwerte (50 Hz, 60 Hz) besitzen kann und dass mittels der gemessenen Perioden (T_{N}) des Netzfrequenz-Taktsignals der Frequenzwert des letzteren ermittelt wird zwecks Wahl eines zugehörigen Teilungsfaktors zur Ableitung der Frequenz (f_{T}) des Taktsignals (CL1) von der Netzfrequenz (f_{N}).

## Claims

1. Procedure for deriving a frequency (f_{T}) of a pulse signal (CL1) from a line frequency (f_{N}), whereby periods (T_{N}) of a line frequency pulse signal having the line frequency (f_{N}) are measured with the help of a measured frequency (F_{M}) derived from an oscillator frequency (f_{Q}), preferably a quartz oscillator frequency, **characterised by** the fact that the frequency (f_{N}) is used for the production of the frequency (f_{T}) of the pulse signal (CL1), if the measured periods (T_{N}) of tHe line frequency pulse signal lie within given tolerance limits, otherwise the frequency (f_{T}) of the pulse signal (CL1) is derived from the oscillator frequency (f_{Q}).

2. Procedure according to claim I, **characterised by** the fact that the measured frequency (f_{M}), derived from the oscillator frequency (f_{Q}) and the frequency (f_{T}) of the pulse signal (CLI), derived from the oscillator frequency (f_{Q}), are calibrated.

3. Procedure according to one of the claims 1 to 2, **characterised by** the fact that the frequency (f_{N}) can possess at least two frequency values (50 Hz, 60 Hz) and that, by means of the measured periods (T_{N}) of the line frequency pulse signal, the frequency value of the latter is determined for the purpose of choosing an associated dividing factor for deriving the frequency (f_{T}) of the pulse signal (CL1) from the line frequency (f_{N}).

## Revendications

1. Procédure pour dériver une fréquence (f_{T})d'un signal de synchronisation (CL1) à partir d'une fréquence de réseau (f_{N}), auquel cas des périodes (T_{N}) d'un signal de synchronisation de la fréquence de réseau ayant la fréquence de réseau (f_{N}) sont mesurés à l'aide d'une fréquence de métrage (f_{M}) dérivée d'une fréquence oscillatoire (f_{Q}), de préférence une fréquence d'oscillateur piézoélectrique, **caractérisée par le fait que** la fréquence de réseau (f_{N}) est utilisée pour générer la fréquence (f_{T}) du signal de synchronisation (CL 1), si les périodes mesurées (T_{N}) du signal de synchronisation de la fréquence de réseau sont situées à l'intérieur de seuils de tolérance alloués, autrement la fréquence (f_{T}) du signal de synchronisation (CL1) est dérivée de la fréquence oscillatoire (f_{Q}).

2. Procédure selon la revendication 1, **caractérisée par le fait que** la fréquence de métrage (f_{M}), dérivée de la fréquence oscillatoire (f_{Q}) et la fréquence (f_{T}) du signal de synchronisation (CLI), dérivée de la fréquence oscillatoire(f_{Q}), sont calibrées.

3. Procédure selon une des revendications de 1 à 2, **caractérisée par le fait que** la fréquence de réseau (f_{N}) peut posséder au moins deux valeurs de fréquence (50 Hz, 60 Hz) et qu'à l'aide des périodes (T_{N}) mesurées du signal de synchronisation de la fréquence de réseau, la valeur de fréquence du tout dernier est déterminée dans le but de choisir un facteur de division correspondant pour dériver la fréquence (f_{T}) du signal de synchronisation (CL1) de la fréquence de réseau (f_{N}).
